# EUROPEAN PATENT APPLICATION

(11) **EP 4 024 410 A1**
(43) Date of publication of application: **06.07.2022**
(21) Application number: 20859253.5
(22) Date of filing: 26.08.2020
(51) Int. Cl.: G16Z 99/00, G01M 17/007

(54) **SIMULATION SYSTEM, SIMULATION PROGRAM, AND SIMULATION METHOD**

(30) Priority: 26.08.2019 JP 2019154125
(71) Applicant: Global Security Inc., Kawasaki-shi, Kanagawa, 213-0012 (JP)
(72) Inventor: TAKENOUE, Noriaki, Kawasaki-shi, Kanagawa 213-0012 (JP)
(74) Representative: Markfort, Iris-Anne Lucie
(86) International application number: PCT/JP2020/032194
(87) International publication number: WO 2021/039845

(57) **Abstract**

A plurality of time wheels, in which a plurality of step sizes of time evaluated as subsequent times in discrete time are set as tags and an event is registered in association with the tags, are generated as a hierarchical time wheel to correspond to a start-up time of the event ranging over a plurality of time tiers having different time units; the event is registered in association with the tags of the plurality of time wheels of the hierarchical time wheel; an error generated between the start-up time stored in the event and the start-up time at which the event is actually started is adjusted on the basis of a difference between a first designated position indicating a current time set in advance for a first time wheel corresponding to any of the time tiers of the hierarchical time wheel, and an n-th designated position indicating a current time set in advance for an n-th time wheel corresponding to a lower-order time tier than the first time wheel; and the event associated with the tags is started when the first designated position of the first time wheel and the n-th designated position of the n-th time wheel coincide with the start-up time of the event.

## Description

### Technical Field

The present invention relates to a simulation system, a simulation program, and a simulation method, and particularly to, a simulation system, a simulation program, and a simulation method for simulating a simulation model including a plurality of events in each of which a start-up time for start-up in any coordinate space is stored.

### Background Art

For example, for a simulation model in which various events such as the actions of the military in military operations and the driving conditions of autonomous driving vehicles in a vehicle driving environment exist, a technique of analyzing and evaluating an object by simulation based on such a simulation model is proposed.

Patent Literature 1 discloses that, in a simulation system for performing simulation based on a logical circuit, a time wheel for uniquely determining registration of an event is used to skip a time at which an event does not occur and to increase a simulation speed.

### Citation List

### Patent Literature

Patent Literature 1: Japanese Patent Application Laid-open No. Hei 10-340290

### Disclosure of Invention

### Technical Problem

Incidentally, if a simulation model in which various events exist is simulated in the simulation system as described above, it is convenient to flexibly construct a time wheel such that an event with a stored start-up time ranging over a plurality of time tiers having different time units can be registered in time wheels corresponding to respective time tiers, and that the event is started at an accurate start-up time in accordance with the simulation model.

The present invention has been made in view of the circumstances described above, and it is an object of the present invention to provide a simulation system, a simulation program, and a simulation method that have high versatility and are capable of constructing a time wheel such that an event is started at an accurate start-up time in accordance with a simulation model.

### Solution to Problem

In order to achieve the above-mentioned object, according to the present invention, a simulation system for simulating a simulation model including a plurality of events in each of which a start-up time for start-up in any coordinate space is stored is characterized by including: a time wheel generation module that generates, as a hierarchical time wheel, a plurality of time wheels in which a plurality of step sizes of time evaluated as subsequent times in discrete time are set as tags and the event is registered in association with the tags, to correspond to the start-up time of the event ranging over a plurality of time tiers having different time units; and an event registration module that registers the event by registering the event in association with the tags of the plurality of time wheels of the hierarchical time wheel generated by the time wheel generation module, in which an error generated between the start-up time stored in the event and the start-up time at which the event is actually started is adjusted on a basis of a difference between a first designated position indicating a current time set in advance for a first time wheel when the time wheel corresponding to any of the time tiers of the hierarchical time wheel is assumed as the first time wheel, and an n-th designated position indicating a current time set in advance for an n-th time wheel when the time wheel corresponding to a lower-order time tier than the first time wheel is assumed as the n-th time wheel, and the event associated with the tags is started when the first designated position of the first time wheel and the n-th designated position of the n-th time wheel coincide with the start-up time of the event.

As a result, the hierarchical time wheel can be generated such that the event in which the start-up time ranging over the plurality of time tiers having different time units is stored can be registered in the time wheels corresponding to the respective time tiers.

Further, the error generated between the start-up time stored in the event and the start-up time at which the event is actually started is adjusted, and thus it is possible to start the event at a desired start-up time.

Therefore, since the hierarchical time wheel can be flexibly constructed to start the event at an accurate start-up time in accordance with the simulation model, a simulation system with high versatility is achieved.

The simulation system is characterized in that the time wheel generation module of the simulation system sets the number of tags to any number in accordance with the simulation model when the hierarchical time wheel is generated.

Further, the simulation system is characterized in that the time wheel generation module registers, in a memory, the plurality of time wheels of the hierarchical time wheel generated to correspond to the time tiers of the start-up time of the event, and the event registration module registers the event in association with the tags of the plurality of time wheels of the hierarchical time wheel registered in the memory by the time wheel generation module.

The simulation system is characterized in that the event registration module of the simulation system stores, as an offset correction value, the current time indicated by the n-th designated position of the n-th time wheel of the hierarchical time wheel, and adjusts the error in the start-up time of the event on a basis of the offset correction value when the event is started.

The simulation system is characterized in that the time wheels corresponding to the plurality of time tiers constituting the hierarchical time wheel generated by the time wheel generation module are stored, and the time wheels and the hierarchical time wheel are associated with each other by storing the time wheels.

Further, the simulation system is characterized in that when the event is progressed from a start point of the tag to an end point of the tag of the n-th time wheel toward start of the event in the time tier of the n-th time wheel in the hierarchical time wheel, the event is progressed from the current tag to a subsequent tag of the first time wheel toward the start of the event in the time tier of the first time wheel.

Besides, the simulation system is characterized in that when a time wheel corresponding to a higher-order time tier than the first time wheel is present, the event associated with the tags of the time wheel corresponding to the higher-order time tier is started by progressing the event from the current tag to the subsequent tag of the first time wheel toward the start of the event in the time tier of the first time wheel.

Further, the simulation system is characterized in that when the event started with reference to the first time wheel in the hierarchical time wheel is assumed as a first event, the event started with reference to the n-th time wheel in the hierarchical time wheel is assumed as an n-th event, and the first event and the n-th event are started on a basis of the time tier corresponding to the first time wheel, the n-th event is repetitively started on a basis of the time tier corresponding to the n-th time wheel such that the time tier of the first time wheel and the time tier of the n-th time wheel coincide with each other.

Meanwhile, the simulation system is characterized in that the event registration module registers, as the event, a time at which an entity included in the simulation model and disposed in the coordinate space starts to act, in association with the tags of the time wheels.

Incidentally, the simulation model may be an evaluation of an autonomous driving vehicle.

In order to achieve the above-mentioned object, according to the present invention, a simulation system including a calculator that simulates a simulation model including a plurality of events in each of which a start-up time for start-up in any coordinate space is stored is characterized by including: a hierarchical time wheel including a plurality of time wheels that are generated to correspond to the start-up time of the event ranging over a plurality of time tiers having different time units and in which a plurality of step sizes of time evaluated as subsequent times in discrete time are set as tags and the event is registered in association with the tags, the hierarchical time wheel being executed on the calculator in a state where the time wheels are concealed; a simulation program that generates the hierarchical time wheel and registers the event by registering the event in association with the tags of the plurality of time wheels of the generated hierarchical time wheel; and application software that generates an entity included in the simulation model and disposed in the coordinate space.

In order to achieve the above-mentioned object, according to the present invention, a simulation program for simulating a simulation model including a plurality of events in each of which a start-up time for start-up in any coordinate space is stored is characterized by including: a time wheel generation module that generates, as a hierarchical time wheel, a plurality of time wheels in which a plurality of step sizes of time evaluated as subsequent times in discrete time are set as tags and the event is registered in association with the tags, to correspond to the start-up time of the event ranging over a plurality of time tiers having different time units; and an event registration module that registers the event by registering the event in association with the tags of the plurality of time wheels of the hierarchical time wheel generated by the time wheel generation module, in which an error generated between the start-up time stored in the event and the start-up time at which the event is actually started is adjusted on a basis of a difference between a first designated position indicating a current time set in advance for a first time wheel when the time wheel corresponding to any of the time tiers of the hierarchical time wheel is assumed as the first time wheel, and an n-th designated position indicating a current time set in advance for an n-th time wheel when the time wheel corresponding to a lower-order time tier than the first time wheel is assumed as the n-th time wheel, and the event associated with the tags is started when the first designated position of the first time wheel and the n-th designated position of the n-th time wheel coincide with the start-up time of the event.

In order to achieve the above-mentioned object, according to the present invention, a simulation method of simulating a simulation model including a plurality of events in each of which a start-up time for start-up in any coordinate space is stored is characterized by including: generating, as a hierarchical time wheel, a plurality of time wheels in which a plurality of step sizes of time evaluated as subsequent times in discrete time are set as tags and the event is registered in association with the tags, to correspond to the start-up time of the event ranging over a plurality of time tiers having different time units; registering the event by registering the event in association with the tags of the plurality of time wheels of the hierarchical time wheel generated by the time wheel generation module; adjusting an error generated between the start-up time stored in the event and the start-up time at which the event is actually started on a basis of a difference between a first designated position indicating a current time set in advance for a first time wheel when the time wheel corresponding to any of the time tiers of the hierarchical time wheel is assumed as the first time wheel, and an n-th designated position indicating a current time set in advance for an n-th time wheel when the time wheel corresponding to a lower-order time tier than the first time wheel is assumed as the n-th time wheel; and starting the event associated with the tags when the first designated position of the first time wheel and the n-th designated position of the n-th time wheel coincide with the start-up time of the event.

### Advantageous Effects of Invention

According to the present invention, a simulation system is achieved, which has high versatility and is capable of flexibly constructing a hierarchical time wheel such that an event is started at an accurate start-up time in accordance with a simulation model. Brief Description of Drawings
[Fig. 1] Fig. 1 is a diagram for describing the outline of a simulation system according to an embodiment of the present invention.
[Fig. 2] Fig. 2 is a block diagram for describing the outline of a configuration of a calculator of the simulation system according to the embodiment.
[Fig. 3] Fig. 3 is a block diagram for describing the outline of a configuration of a hierarchical time wheel stored in a memory of the calculator of the simulation system according to the embodiment.
[Fig. 4] Fig. 4 is a diagram for describing the outline of a configuration of a plurality of time wheels constituting the hierarchical time wheel stored in the memory of the calculator of the simulation system according to the embodiment.
[Fig. 5] Fig. 5 is a diagram for describing the outline of the operation of the hierarchical time wheel stored in the memory of the calculator of the simulation system according to the embodiment.
[Fig. 6] Fig. 6 is a flowchart for describing the outline of the operation of the hierarchical time wheel stored in the memory of the calculator of the simulation system according to the embodiment.
[Fig. 7] Fig. 7 is a block diagram for describing the outline of a configuration of storage of the calculator of the simulation system according to the embodiment.
[Fig. 8] Fig. 8 is a block diagram for describing the outline of a configuration of scenario data in the storage of the calculator of the simulation system according to the embodiment.
[Fig. 9] Fig. 9 is a flowchart for describing the outline of processing of a time wheel generation module in a simulation program stored in the storage of the calculator of the simulation system according to the embodiment.
[Fig. 10] Fig. 10 is a flowchart for describing the outline of processing of an event registration module in the simulation program stored in the storage of the calculator of the simulation system according to the embodiment.
[Fig. 11] Fig. 11 is a conceptual diagram for describing the outline of the processing of the event registration module in the simulation program stored in the storage of the calculator of the simulation system according to the embodiment.
[Fig. 12] Fig. 12 is a flowchart for describing the outline of the use procedure of the simulation system according to the embodiment.
[Fig. 13] Fig. 13 is a diagram for describing the outline of an event model in which an event to be started in the simulation system according to the embodiment is generated.
[Fig. 14] Fig. 14 is a diagram for describing the outline of a simulation system according to another embodiment of the present invention. Mode(s) for Carrying Out the Invention

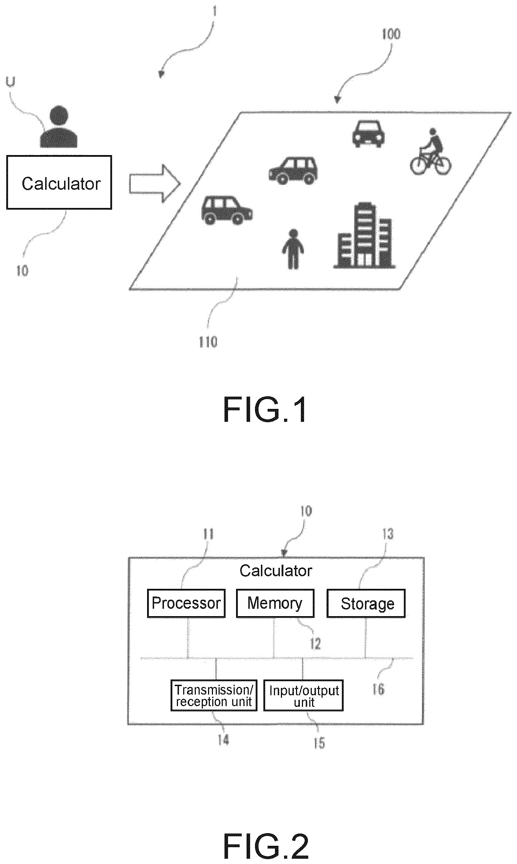

Next, a simulation system according to an embodiment of the present invention will be described with reference to Figs. 1 to 13.

Fig. 1 is a diagram for describing the outline of a simulation system according to this embodiment. As shown in the figure, a simulation system 1 includes a calculator 10 that generates a simulation model 100.

In this embodiment, the simulation model 100 is used to evaluate autonomous driving vehicles. The activities of entities such as evaluation vehicles serving as an object to be evaluated, other vehicles, bicycles, and pedestrians are registered as events, and the registered events are started in a coordinate space 110.

The calculator 10 evaluates an object on the basis of the simulation model 100 generated through the operation of a user U. In this embodiment, the calculator 10 is implemented by various computers such as a computer that functions as a server, a desktop computer, a laptop computer, a smart phone, and a tablet computer.

Fig. 2 is a block diagram for describing the outline of a configuration of the calculator 10. As shown in the figure, the calculator 10 mainly includes a processor 11, a memory 12, storage 13, a transmission/reception unit 14, and an input/output unit 15, which are electrically connected to each other via a bus 16.

The processor 11 is an arithmetic unit that controls the operation of the calculator 10, controls the transmission and reception of data between the elements, and performs processing necessary for executing programs, for example.

The processor 11 is, for example, a central processing unit (CPU) in this embodiment and executes programs that are stored in the storage 13, which will be described later, and expanded in the memory 12 to perform respective processes.

The memory 12 includes a main storage device including a volatile storage device such as a dynamic random access memory (DRAM), and an auxiliary storage device including a non-volatile storage device such as a flash memory or a hard disc drive (HDD).

The memory 12 is used as a work area of the processor 11 and also stores a basic input/output system (BIOS) executed at the time of starting the calculator 10, various types of setting information, and the like.

In this embodiment, when a hierarchical time wheel to be described later is generated, time wheels constituting the hierarchical time wheel are registered as a dictionary, and the hierarchical time wheel is stored.

The storage 13 stores programs, information used for various types of processing, and the like. The configuration of the storage 13 will be described later.

The transmission/reception unit 14 connects the calculator 10 to a network such as an Internet network and may include a short-range communication interface such as Bluetooth (registered trademark) or BLE (Bluetooth Low Energy).

The input/output unit 15 is an interface to which an input/output device is connected. As the input/output device, for example, a keyboard, a mouse, or a display is assumed.

The bus 16 transmits, for example, address signals, data signals, and various control signals between the processor 11, the memory 12, the storage 13, the transmission/reception unit 14, and the input/output unit 15 that are connected to each other.

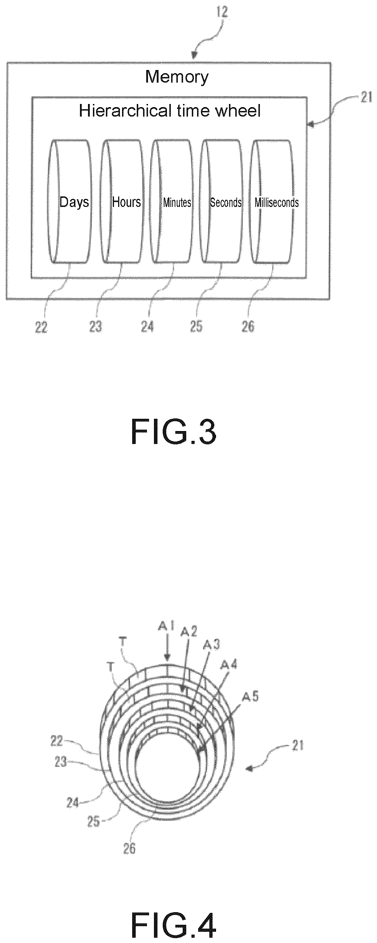

Fig. 3 is a diagram for describing the outline of a configuration of a hierarchical time wheel 21 that is registered as a dictionary and stored in the memory 12. As shown in the figure, the hierarchical time wheel 21 includes a plurality of time wheels corresponding to a plurality of time tiers having different time units, and in this embodiment, includes time wheels 22 to 26 corresponding to the respective time tiers of "days", "hours", "minutes", "seconds", and "milliseconds" in accordance with the simulation model 100.

Fig. 4 is a diagram for describing the outline of a configuration of each of the time wheels 22 to 26 constituting the hierarchical time wheel 21. As shown in the figure, each of the time wheels 22 to 26 is a time-table-type storage area, in which a step size of time evaluated as a subsequent time in discrete time is set as a tag T, and such tags T are arranged in a circular manner with the largest number of a time difference of event processing.

In this embodiment, the number of tags T in each of the time wheels 22 to 26 is set to any number in accordance with the simulation model 100.

For example, in the case of the time wheel 26 corresponding to the time tier of "milliseconds", while the number of tags T is 1000 tags and a standard step size per tag is 1 millisecond in this embodiment, the step size per tag can be set to 10 milliseconds with the number of tags T being 100 tags, or the step size per tag can be set to 100 milliseconds with the number of tags T being 10 tags.

The number of tags T in each of the time wheels 22 to 26 can be set only when the hierarchical time wheel 21 is generated. This prevents the generated simulation model 100 from being inadvertently altered.

As described above, the number of tags T in each of the time wheels 22 to 26 is set arbitrarily, and thus it is possible to smoothly cope with the case of performing simulation such as processing of a video in units of frame per second (fps), for example.

An event is registered in association with the tags T of the time wheels 22 to 26. When avails A1 to A5, which are the first designated position to the n-th designated position each indicating the current time and are respectively preset for the time wheels 22 to 26, coincide with a start-up time of the event associated with the tags T, the event is started.

Each of the time wheels 22 to 26 is concealed by the hierarchical time wheel 21 from a program that illegally enters the memory 12, and thus the time wheels 22 to 26 are prevented from being detected and altered by the program.

Further, the time wheels 22 to 26 are made invisible by the hierarchical time wheel 21 from the user U who operates the calculator 10, and thus the user U does not need to set the time wheels 22 to 26 constituting the hierarchical time wheel 21 when the hierarchical time wheel 21 is generated. Therefore, simulation can be easily executed.

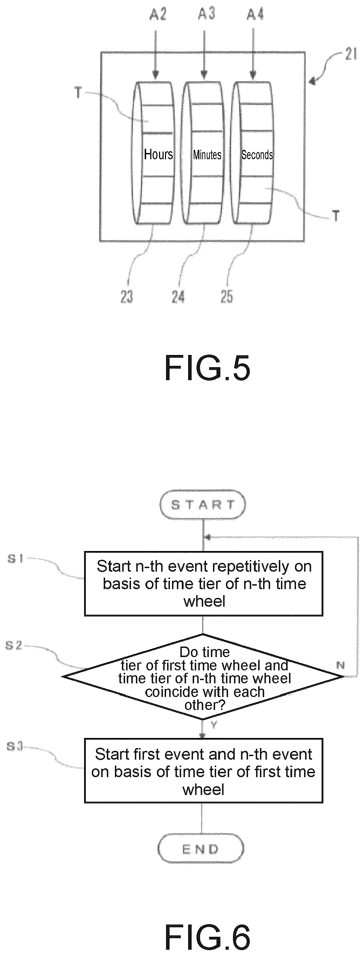

Fig. 5 is a diagram for describing the outline of the operation of the hierarchical time wheel 21. As shown in the figure, when the time wheels 23 to 25 corresponding to the respective time tiers of "hours", "minutes", and "seconds" are configured, for example, the time wheel 24 is set as a first time wheel.

In this case, it is assumed that the time wheel 25 corresponding to the time tier of "seconds", which is a lower-order time tier than the time wheel 24, is the n-th time wheel. When an event progresses from a tag T at the start point, at which the avail A4 of the time wheel 25 is located, to a tag T at the end point, the event progresses from the current tag T, at which the avail A3 of the time wheel 24 serving as the first time wheel is located, to a subsequent tag T.

When the event progresses from the current tag T, at which the avail A3 of the time wheel 24 is located, to the subsequent tag T, the event registered in the time wheel 23 corresponding to the time tier of "hours", which is a higher-order time tier than the time wheel 24, is started in this embodiment.

Fig. 6 is a flowchart for describing the outline of the operation of the hierarchical time wheel 21.

For example, it is assumed that a first event is started with the time wheel 25 corresponding to the time tier of "seconds" in the hierarchical time wheel 21 being used as a the first time wheel, and an n-th event repeated in 100 milliseconds is started with the time wheel 26 corresponding to the time tier of "milliseconds" in the hierarchical time wheel 21 being used as the n-th time wheel.

In this case, the n-th event started on the basis of "milliseconds" serving as the time tier of the time wheel 26 that is the n-th time wheel is included in the step size of the time wheel 25 corresponding to the time tier of the "seconds". Thus, in order to evaluate the n-th event in the time tier of "seconds", the n-th event needs to be repetitively started 10 times on the basis of "milliseconds" serving as the time tier of the time wheel 26.

However, if the first event and the n-th event are started on the basis of "seconds" serving as the time tier of the time wheel 25 that is the first time wheel, the n-th event is started only once in a manner similar to the first event started on the basis of "seconds" serving as the time tier of the time wheel 25.

As described above, if the n-th event, which cannot be properly evaluated in the time tier of "seconds" unless it is repetitively started 10 times, is evaluated in the time tier of "seconds" by one-time start-up of the event, there arises a problem in that it is impossible to perform proper evaluation.

In this regard, in this embodiment, the n-th event is repetitively started 10 times on the basis of the time tier of "milliseconds" of the time wheel 26 in Step S1.

If the time tier of "seconds" of the time wheel 25, which is the first time wheel, and the time tier of "milliseconds" of the time wheel 26, which is the n-th time wheel, coincides with each other in Step S2 by the repetitive start-up of the n-th event, the first event and the n-th event are started on the basis of "seconds" serving as the time tier of the time wheel 25 that is the first time wheel in Step S3.

If simulation is performed using the time wheels having the above configuration, the arithmetic processing is executed while skipping the tags that are not registered in association with the event, and thus the processing in the simulation can be performed at high speed.

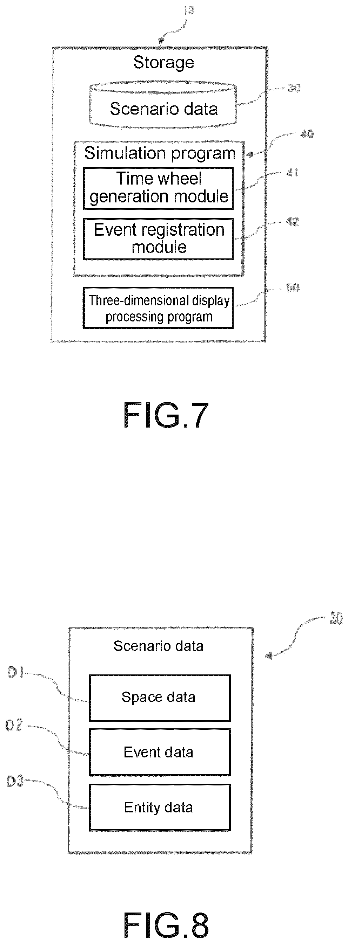

Fig. 7 is a block diagram for describing the outline of a configuration of the storage 13. As shown in the figure, the storage 13 includes scenario data 30, a simulation program 40, and a three-dimensional display processing program 50 that are stored in the storage area of the storage 13.

Fig. 8 is a block diagram for describing the outline of a configuration of the scenario data 30. As shown in the figure, the scenario data 30 includes space data D1, event data D2, and entity data D3.

In this embodiment, the space data D1 is data for generating the coordinate space 110 of the simulation model 100, a road surface on which an autonomous driving vehicle or the like that is an entity runs in the coordinate space 110, and the like.

The event data D2 is data for generating an event to be started in the simulation model 100, such as running of an emergency vehicle, a change of a signal, or pedestrian walking.

In this embodiment, the entity data D3 is data for generating entities that are mobile bodies such as autonomous driving vehicles as an object, other vehicles, bicycles, and pedestrians.

As shown in Fig. 7, the simulation program 40 includes a time wheel generation module 41 and an event registration module 42.

In this embodiment, the time wheel generation module 41 is a module that generates, as the hierarchical time wheel 21, any time wheels 22 to 26 that are required in accordance with the simulation model 100.

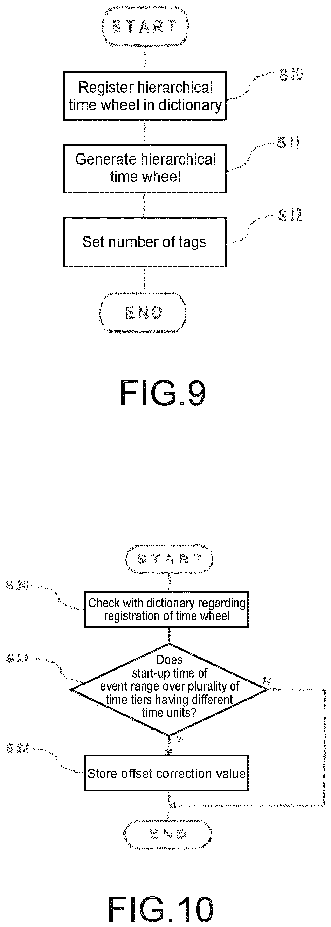

Fig. 9 is a flowchart for describing the outline of the processing of the time wheel generation module 41. As shown in the figure, when generating the hierarchical time wheel 21 so as to correspond to the time tier of the start-up time of an event to be started in the simulation model 100, in Step S10, the time wheel generation module 41 registers the generated hierarchical time wheel 21 as a dictionary in the memory 12 for each of the time wheels 22 to 26.

For example, if the time tier of the start-up time of the event to be started in the simulation model 100 ranges over "hours", "minutes", and "seconds", the time wheels 23 to 25 of the generated hierarchical time wheel 21 are registered as a dictionary in the memory 12.

As described above, the generated time wheels 23 to 25 are registered as a dictionary in the memory 12, and unnecessary time wheels 22 to 26 are not unnecessarily generated in the simulation model 100, and thus a decrease in the processing capacity of the simulation system 1 is avoided.

In Step S11, any time wheels 22 to 26 registered as a dictionary in the memory 12, for example, the time wheels 23 to 25 in this embodiment, are generated as the hierarchical time wheel 21 and then stored in the memory 12.

When the time wheels 23 to 25 constituting the hierarchical time wheel 21 are registered as a dictionary and stored in the memory 12, the time wheels 23 to 25 and the hierarchical time wheel 21 are associated with each other.

This allows the hierarchical time wheel 21 to directly progress the time wheels 23 to 25, in which an event is registered, toward the start of the event.

In the next Step S12, the number of tags T in each of the time wheels 22 to 26 is set to any number of tags T in accordance with the simulation model 100.

In this embodiment, the event registration module 42 is a module that registers an event in association with any tags T of any time wheels 22 to 26 of the hierarchical time wheel 21 generated by the time wheel generation module 41.

In the event registered in any time wheels 22 to 26, a time difference of event processing is stored as a start-up time. If the start-up time of the event ranges over a plurality of time tiers having different time units, the event is registered in all or any of the plurality of time wheels 22 to 26 of the hierarchical time wheel 21.

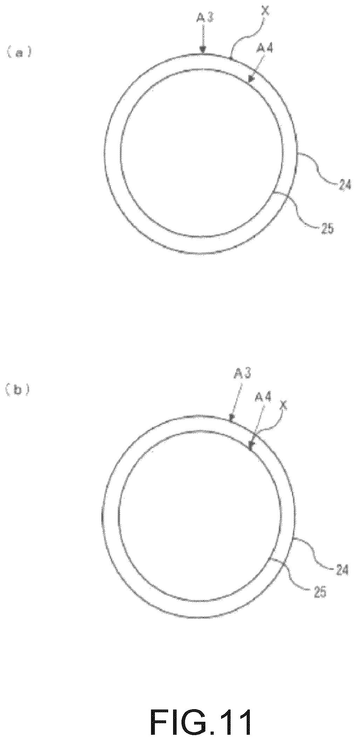

Fig. 10 is a flowchart for describing the outline of the processing of the event registration module 42. Fig. 11 is a conceptual diagram for describing the outline of the processing of the event registration module 42.

As shown in Fig. 10, when an event is registered in the event registration module 42, in Step S20, it is checked with the dictionary whether or not any time wheels 22 to 26 corresponding to the start-up time of the event ranging over a plurality of time tiers are generated as the hierarchical time wheel 21 and registered in the memory 12.

For example, if the time tier of the start-up time of the event ranges over "minutes" and "seconds", it is checked with the dictionary whether or not the time wheels 24 and 25 corresponding to the time tiers of "minutes" and "seconds" are registered in the memory 12.

Subsequently, when the event is to be registered in the plurality of time wheels 22 to 26 of the hierarchical time wheel 21, if the start-up time of the event ranges over a plurality of time tiers having different time units in Step S21, an error occurs between the start-up time stored in the event and the start-up time at which the event is actually started.

For example, as shown in (a) of Fig. 11, in a case where the avail A3 of the time wheel 24 corresponding to the time tier of "minutes" is located at 0 minutes and where the avail A4 of the time wheel 25 corresponding to the time tier of "seconds" is located at 10 seconds, for example, an event X with the stored start-up time of 2 minutes 10 seconds is registered in the time wheel 24.

At that time, if the time wheel 25 corresponding to the time tier of "seconds", which is the lower-order time tier than the time wheel 24, is assumed as the n-th time wheel, the event X progresses with the tag T of 10 seconds at which the avail A4 of the time wheel 25 is located being used as the start point, and after 50 seconds elapse, with the tag T of 0 seconds at which the avail A4 of the time wheel 25 is located being used as the end point.

Along with this, the event X progresses while the avail A3 of the time wheel 24 is located from the tag T of 0 minutes to the tag T of 1 minute toward the start-up of the event X in the time tier of "minutes".

Subsequently, as shown in (b) of Fig. 11, when the avail A3 of the time wheel 24 is located at the tag T of 2 minutes and when the avail A4 of the time wheel 25 is located at the tag T of 10 seconds, the event X in which the start-up time is stored as 2 minutes 10 seconds is started.

However, when the event X is registered in the time wheel 24, the time at which the avails A3 and A4 are located is 0 minutes 10 seconds. Thus, it should be assumed that the event X with the start-up time stored as 2 minutes 10 seconds is started when the avails A3 and A4 are located at 2 minutes 20 seconds.

In such a manner, an error occurs between the start-up time stored in the event X and the start-up time at which the event X is actually started on the basis of the difference between the time at which the avail A3 is located and the time at which the avail A4 is located.

At that time, as shown in Fig. 10, in Step S22, a time at which any avails A2 to A5 of any time wheels 23 to 26 of the lower-order time tiers than any time wheels 22 to 25 of the highest time tiers are located is stored as an offset correction value.

For example, as shown in (a) and (b) of Fig. 11, when the event X is registered in the time wheel 24, 10 seconds at which the avail A4 of the time wheel 25 that is the lower-order time wheel is located are stored as an offset correction value.

As a result, the offset correction value is added when the event X progresses in the time wheel 25 corresponding to the time tier of "seconds", and the error generated between the start-up time stored in the event X and the start-up time at which the event X is actually started is adjusted.

Therefore, in this embodiment, the event X is started when the avail A3 and the avail A4 are located at 2 minutes 20 seconds.

As shown in Fig. 7, the three-dimensional display processing program 50 is a program for processing the simulation model 100 to be displayed three-dimensionally on a display connected to the calculator 10.

Next, the use procedure of the simulation system 1 according to this embodiment will be described.

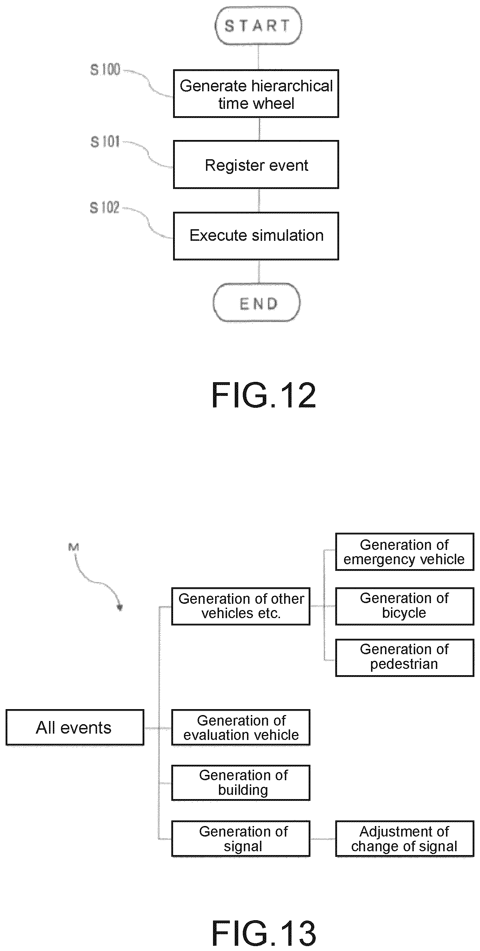

Fig. 12 is a flowchart for describing the outline of the use procedure of the simulation system 1. In this embodiment, first, the hierarchical time wheel 21 generated in accordance with the simulation model 100 and an event started in the simulation model 100 is registered as a dictionary in the memory 12 for each of the time wheels 22 to 26, and the hierarchical time wheel 21 is generated in Step S100 as shown in the figure.

For example, if the start-up time of the event ranges over the time tier of "hours", the time tier of "minutes", and the time tier of "seconds", the time wheels 23 to 25 are registered as a dictionary and stored, and the hierarchical time wheel 21 is generated using the time wheels 23 to 25.

At that time, any number is set for the number of tags T in each of the time wheels 23 to 25 in accordance with the simulation model 100.

Subsequently, in Step S101, the event is registered. In this embodiment, as shown in Fig. 13, an event to be registered is generated from derivation of an event model M created as the event data D2, and any event based on the simulation model 100 is registered.

In this embodiment, for example, times, positions, and the like at which evaluation vehicles serving as an entity generated on the basis of the entity data D3, other vehicles serving as an entity likewise, such as emergency vehicles and bicycles, and the like appear in the coordinate space 110 are registered as events.

In Step S101, it is checked with the dictionary whether or not the time wheels 23 to 25 corresponding to the start-up time of the event are registered as the hierarchical time wheel 21 in the memory 12.

When the event is registered in the time wheels 23 to 25, if the start-up time of the event to be registered ranges over a plurality of time tiers having different time units, in this embodiment, the time at which the avails A3 and A4 of the time wheels 24 and 25 are located is stored as an offset correction value.

Next, in Step S102, simulation is executed on the basis of the simulation model 100, and the autonomous driving of the evaluation vehicles is evaluated on the basis of the simulation regarding the autonomous driving of the evaluation vehicles. At that time, in this embodiment, the simulation model 100 is displayed three-dimensionally on a display connected to the calculator 10.

As described above, according to the simulation system 1 of this embodiment, it is possible to generate the hierarchical time wheel 21 such that an event in which a start-up time ranging over a plurality of time tiers having different time units is stored can be registered in the time wheels 22 to 26 corresponding to the respective time tiers.

Furthermore, the error between the start-up time stored in the event and the start-up time at which the event is actually started is adjusted on the basis of the offset correction value stored by the event registration module 42, and thus the event can be started at a desired start-up time.

Therefore, since the hierarchical time wheel 21 can be flexibly constructed so as to start the event at an accurate start-up time in accordance with the simulation model, the simulation system 1 with high versatility is achieved.

### (Another Embodiment)

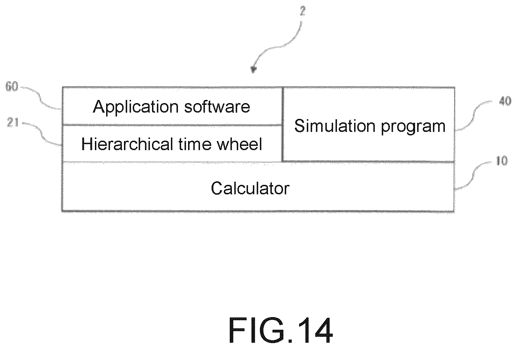

Next, a simulation system 2 according to another embodiment of the present invention will be described with reference to Fig. 14.

Note that, in the simulation system 2, the same reference symbols are assigned to the components similar to those in the simulation system 1, and description thereof will be omitted.

As shown in the figure, the simulation system 2 is achieved by a layer model including a calculator 10, a hierarchical time wheel 21 executed on the calculator 10, a simulation program 40 for generating the hierarchical time wheel 21 and registering an event in the generated hierarchical time wheel 21, and application software 60 for generating entities on the hierarchical time wheel 21.

In this simulation system 2, the hierarchical time wheel 21 can be used as the operating system (OS) of the calculator 10 that simulates a simulation model.

On the other hand, in the simulation system 2, an environment in which the application software 60 for creating entities that are registered as events on the hierarchical time wheel 21 and disposed in a coordinate space is developed is provided, for example, by an application programming interface (API) or by exposing a source code of the application software 60.

In this embodiment, the application software 60 generates entities that are included in the simulation model and disposed in the coordinate space.

For example, in the simulation model 100, the application software 60 may be assumed as mobile body generating application software for generating a mobile body such as an autonomous driving vehicle or another vehicle, space generating application software for generating a space such as a coordinate space 110 or a road surface on which an autonomous driving vehicle or the like runs in the coordinate space 110, or the like.

Further, for example, it may be assumed as application software relating to the utility of entities, such as direction controlling application software for controlling the traveling direction of a mobile body, or display controlling application software for controlling displaying of the simulation model 100 on a display.

Note that the simulation program 40 may be configured to be implemented also by the application software 60.

As described above, according to the simulation system 2 of this embodiment, the time wheels 22 to 26 constituting the hierarchical time wheel 21 are concealed by the hierarchical time wheel 21 and executed on the calculator 10, and thus it is possible to prevent the hierarchical time wheel 21 from being detected and altered by a program that illegally enters the memory 12.

On the other hand, the time wheels 22 to 26 are also made invisible by the hierarchical time wheel 21 from a developer who develops the application software 60, and thus the developer does not need to set the time wheels 22 to 26 constituting the hierarchical time wheel 21 when developing the application software 60, and can easily develop the application software 60.

Therefore, in a secure environment in which the hierarchical time wheel 21 is not altered by a program that enters the memory 12, the hierarchical time wheel 21 can be flexibly constructed in accordance with the simulation model while using the application software 60 generated without being aware of the time wheels 22 to 26, thus achieving a simulation system 2 with high versatility.

Note that the present invention is not limited to the embodiment and the other embodiment described above, and various modifications can be made without departing from the spirit of the invention.

In the above embodiments, the case where the simulation model 100 evaluates autonomous driving vehicles has been described. However, for example, the present invention can be used for various evaluations such as an operation evaluation of a railway traffic network or a bus traffic network, an operation evaluation of military, an evaluation of an air traffic control system, and an evaluation of a flight path of a drone.

- 1, 2: simulation system
- 10: calculator
- 21: hierarchical time wheel
- 22 to 26: time wheel
- 40: simulation program
- 41: time wheel generation module
- 42: event registration module
- 60: application software
- A1 to A5: avail (first designated position to n-th designated position)
- D2: event data
- T: tag

## Claims

1. A simulation system for simulating a simulation model including a plurality of events in each of which a start-up time for start-up in any coordinate space is stored, the simulation system comprising:
a time wheel generation module that generates, as a hierarchical time wheel, a plurality of time wheels in which a plurality of step sizes of time evaluated as subsequent times in discrete time are set as tags and the event is registered in association with the tags, to correspond to the start-up time of the event ranging over a plurality of time tiers having different time units; and
an event registration module that registers the event by registering the event in association with the tags of the plurality of time wheels of the hierarchical time wheel generated by the time wheel generation module, wherein
an error generated between the start-up time stored in the event and the start-up time at which the event is actually started is adjusted on a basis of a difference between a first designated position indicating a current time set in advance for a first time wheel when the time wheel corresponding to any of the time tiers of the hierarchical time wheel is assumed as the first time wheel, and an n-th designated position indicating a current time set in advance for an n-th time wheel when the time wheel corresponding to a lower-order time tier than the first time wheel is assumed as the n-th time wheel, and
the event associated with the tags is started when the first designated position of the first time wheel and the n-th designated position of the n-th time wheel coincide with the start-up time of the event.

2. The simulation system according to claim 1, wherein
the time wheel generation module sets the number of tags to any number in accordance with the simulation model when the hierarchical time wheel is generated.

3. The simulation system according to claim 1 or 2, wherein
the time wheel generation module registers, in a memory, the plurality of time wheels of the hierarchical time wheel generated to correspond to the time tiers of the start-up time of the event, and
the event registration module registers the event in association with the tags of the plurality of time wheels of the hierarchical time wheel registered in the memory by the time wheel generation module.

4. The simulation system according to any one of claims 1 to 3, wherein
the event registration module stores, as an offset correction value, the current time indicated by the n-th designated position of the n-th time wheel of the hierarchical time wheel, and adjusts the error in the start-up time of the event on a basis of the offset correction value when the event is started.

5. The simulation system according to any one of claims 1 to 4, wherein
the time wheels corresponding to the plurality of time tiers constituting the hierarchical time wheel generated by the time wheel generation module are stored, and the time wheels and the hierarchical time wheel are associated with each other by storing the time wheels.

6. The simulation system according to any one of claims 1 to 5, wherein
when the event is progressed from a start point of the tag to an end point of the tag of the n-th time wheel toward start of the event in the time tier of the n-th time wheel in the hierarchical time wheel, the event is progressed from the current tag to a subsequent tag of the first time wheel toward the start of the event in the time tier of the first time wheel.

7. The simulation system according to claim 6, wherein
when a time wheel corresponding to a higher-order time tier than the first time wheel is present, the event associated with the tags of the time wheel corresponding to the higher-order time tier is started by progressing the event from the current tag to the subsequent tag of the first time wheel toward the start of the event in the time tier of the first time wheel.

8. The simulation system according to any one of claims 1 to 7, wherein
when the event started with reference to the first time wheel in the hierarchical time wheel is assumed as a first event, the event started with reference to the n-th time wheel in the hierarchical time wheel is assumed as an n-th event, and the first event and the n-th event are started on a basis of the time tier corresponding to the first time wheel, the n-th event is repetitively started on a basis of the time tier corresponding to the n-th time wheel such that the time tier of the first time wheel and the time tier of the n-th time wheel coincide with each other.

9. The simulation system according to any one of claims 1 to 8, wherein
the event registration module registers, as the event, a time at which an entity included in the simulation model and disposed in the coordinate space starts to act, in association with the tags of the time wheels.

10. The simulation system according to any one of claims 1 to 9, wherein
the simulation model is an evaluation of an autonomous driving vehicle.

11. A simulation system including a calculator that simulates a simulation model including a plurality of events in each of which a start-up time for start-up in any coordinate space is stored, the simulation system comprising:
a hierarchical time wheel including a plurality of time wheels that are generated to correspond to the start-up time of the event ranging over a plurality of time tiers having different time units and in which a plurality of step sizes of time evaluated as subsequent times in discrete time are set as tags and the event is registered in association with the tags, the hierarchical time wheel being executed on the calculator in a state where the time wheels are concealed;
a simulation program that generates the hierarchical time wheel and registers the event by registering the event in association with the tags of the plurality of time wheels of the generated hierarchical time wheel; and
application software that generates an entity included in the simulation model and disposed in the coordinate space.

12. A simulation program for simulating a simulation model including a plurality of events in each of which a start-up time for start-up in any coordinate space is stored, the simulation program comprising:
a time wheel generation module that generates, as a hierarchical time wheel, a plurality of time wheels in which a plurality of step sizes of time evaluated as subsequent times in discrete time are set as tags and the event is registered in association with the tags, to correspond to the start-up time of the event ranging over a plurality of time tiers having different time units; and
an event registration module that registers the event by registering the event in association with the tags of the plurality of time wheels of the hierarchical time wheel generated by the time wheel generation module, wherein
an error generated between the start-up time stored in the event and the start-up time at which the event is actually started is adjusted on a basis of a difference between a first designated position indicating a current time set in advance for a first time wheel when the time wheel corresponding to any of the time tiers of the hierarchical time wheel is assumed as the first time wheel, and an n-th designated position indicating a current time set in advance for an n-th time wheel when the time wheel corresponding to a lower-order time tier than the first time wheel is assumed as the n-th time wheel, and
the event associated with the tags is started when the first designated position of the first time wheel and the n-th designated position of the n-th time wheel coincide with the start-up time of the event.

13. A simulation method of simulating a simulation model including a plurality of events in each of which a start-up time for start-up in any coordinate space is stored, the simulation method comprising:
generating, as a hierarchical time wheel, a plurality of time wheels in which a plurality of step sizes of time evaluated as subsequent times in discrete time are set as tags and the event is registered in association with the tags, to correspond to the start-up time of the event ranging over a plurality of time tiers having different time units;
registering the event by registering the event in association with the tags of the plurality of time wheels of the hierarchical time wheel generated by the time wheel generation module;
adjusting an error generated between the start-up time stored in the event and the start-up time at which the event is actually started on a basis of a difference between a first designated position indicating a current time set in advance for a first time wheel when the time wheel corresponding to any of the time tiers of the hierarchical time wheel is assumed as the first time wheel, and an n-th designated position indicating a current time set in advance for an n-th time wheel when the time wheel corresponding to a lower-order time tier than the first time wheel is assumed as the n-th time wheel; and
starting the event associated with the tags when the first designated position of the first time wheel and the n-th designated position of the n-th time wheel coincide with the start-up time of the event.
